# EUROPEAN PATENT APPLICATION

(11) **EP 4 531 280 A1**
(43) Date of publication of application: **02.04.2025**
(21) Application number: 24203336.3
(22) Date of filing: 27.09.2024
(51) Int. Cl.: H03F 1/02, H03F 3/195, H03F 3/24, H03F 3/68, H03F 3/72

(54) **MULTIGENERATIONAL FRONT-END MODULE (FEM)**

(30) Priority: 29.09.2023 US 202363586807 P; 06.10.2023 US 202363542946 P; 08.12.2023 US 202363607710 P; 20.09.2024 US 202418891610
(71) Applicant: Qorvo US, Inc., Greensboro, NC 27409 (US)
(72) Inventor: BAKER, Scott, Greensboro 27409 (US); MAXIM, George, Greensboro 27409 (US); KANG, Sukchan, Greensboro 27409 (US); WOO, Chong, Greensboro 27409 (US); CAO, May, Greensboro 27409 (US); WEIGAND, Steven, Greensboro 27409 (US); SCHLEICHER, Bernd, Greensboro 27409 (US); DICIOMMA, Rossella, Greensboro 27409 (US); MANGOLD, Tobias, Greensboro 27409 (US)
(74) Representative: D Young & Co LLP

(57) **Abstract**

A multigenerational front-end module (FEM) is disclosed. In particular, a FEM having a single transmission path may include a single power amplifier with supporting elements such as for example, bias levels, load modulation, supply voltages, or the like, that may be reconfigured and tuned so as to allow the single power amplifier to adapt effectively and work with different generations of wireless protocols. The use of such an adaptive, reconfigurable, tunable transmission path allows smaller and more cost-effective FEMs to be provided. Settings for the various changes may be stored in a look-up table (LUT) or the like.

## Description

### PRIORITY APPLICATIONS

The present application claims the benefit of and is related to U.S. Provisional Patent Application Serial No. 63/542,946 filed on October 6, 2023, and entitled "SILICON-AROUND-GAAS CONVERGED 2/3/4/5G FRONT-END MODULE USING RECONFIGURABLE AND ADAPTIVE CMOS SIGNAL PATH AND PROTECTION," the contents of which are incorporated herein by reference in its entirety.

The present application also claims the benefit of and is related to U.S. Provisional Patent Application Serial No. 63/586,807 filed on September 29, 2023, and entitled "HYBRID RECONFIGURABLE AND CLASS ADAPTIVE CONVERGED 2Glin/2Gvramp/3G/4G/5G TX PATH WITH BUCK-BOOST APT FEMs CURRENT," the contents of which are incorporated herein by reference in its entirety.

The present application also claims the benefit of and is related to U.S. Provisional Patent Application Serial No. 63/607,710 filed on December 8, 2023, and entitled "MULTIGENERATIONAL FRONT-END MODULE (FEM)," the contents of which are incorporated herein by reference in its entirety.

The present application also claims the benefit of and is related to U.S. Patent Application Serial No. 18/891,610 filed on September 20, 2024, and entitled "MULTIGENERATIONAL FRONT-END MODULE (FEM)," the contents of which are incorporated herein by reference in its entirety.

### BACKGROUND

### 1. Field of the Disclosure

The technology of the disclosure relates generally to a technique to provide a front-end module (FEM) that will work with multiple generations of wireless standards.

### II. Background

Computing devices abound in modern society, and more particularly, mobile communication devices have become increasingly common. The prevalence of these mobile communication devices is driven in part by the many functions that are now enabled on such devices. Increased processing capabilities in such devices means that mobile communication devices have evolved from pure communication tools into sophisticated mobile entertainment centers, thus enabling enhanced user experiences. With the advent of the myriad functions available to such devices, there has been increased pressure to find ways to increase bandwidth for data transmission to and from the user equipment or other wireless communication devices. This pressure has resulted in the evolution of wireless protocols and a current trend to use higher frequency signals.

While the newer wireless protocols have more bandwidth than the older wireless protocols, the infrastructure deployed to support the older wireless protocols remains deployed in some locales. Further, newer protocols may do some form of aggregation that utilizes signaling in multiple protocols simultaneously to increase bandwidth. Accordingly, many wireless communication devices may include circuitry that supports a plurality of wireless protocols. Providing a cost-effective solution that fits within the space available in commercially viable wireless communication devices provides an opportunity for innovation.

### SUMMARY

Aspects disclosed in the detailed description include a multigenerational front-end module (FEM). In particular, a FEM having a single transmission path may include a single power amplifier with supporting elements such as, for example, bias levels, load modulation, supply voltages, or the like, that may be reconfigured and tuned so as to allow the single power amplifier to adapt effectively and work with different generations of wireless protocols. The use of such an adaptive, reconfigurable, tunable transmission path allows smaller and more cost-effective FEMs to be provided. Settings for the various changes may be stored in a look-up table (LUT) or the like.

In further aspects, much of the tuning and adjustments used to switch between generations may be implemented in a silicon stage that is positioned before a primary amplifier stage that is formed in a different material (e.g., gallium arsenide (GaAs)) along with a second silicon stage that is positioned after the primary amplifier stage. The use of silicon around the primary stage allows for easier implementation of certain features as well as enabling more readily implemented protection loops and/or analog predistortion circuitry.

In this regard, in one aspect, a FEM is disclosed. The FEM includes a main power amplifier, a plurality of adjustable elements associated with the main power amplifier, and a control circuit coupled to each of the plurality of adjustable elements. The control center is configured to, in response to receiving a command to operate the main power amplifier in a second-generation cellular mode, command at least one of the plurality of adjustable elements to change operation based on information in a look-up table, and in response to receiving a second command to operate the main power amplifier in a subsequent generation cellular mode, command the at least one of the plurality of adjustable elements to change operation.

In another aspect, a mobile communication device is disclosed. The mobile communication device includes a baseband processor (BBP), a transceiver circuit coupled to the BBP, an antenna, and a FEM coupled to the antenna and the transceiver circuit. The FEM includes a main power amplifier, a plurality of adjustable elements associated with the main power amplifier, and a control circuit coupled to each of the plurality of adjustable elements. The control circuit is configured to, in response to receiving a command to operate the main power amplifier in a second-generation cellular mode, command at least one of the plurality of adjustable elements to change operation based on information in a look-up table, and in response to receiving a second command to operate the main power amplifier in a subsequent generation cellular mode, command the at least one of the plurality of adjustable elements to change operation.

In another aspect, a method of changing operation of a FEM is disclosed. The method includes receiving an indication at the FEM for operation in a second-generation cellular mode. The method also includes, responsive to receiving the indication, causing at least one adjustable element in the FEM to change operation, receiving a second indication at the FEM for operation in a subsequent generation cellular mode, and responsive to receiving the second indication, causing the at least one adjustable element in the FEM to change operation.

In another aspect, a FEM is disclosed. The FEM includes a primary power amplifier stage and a silicon prestage structure positioned in front of the primary power amplifier stage, the silicon prestage structure comprising a plurality of adjustable elements associated with the primary power amplifier stage. The FEM also includes a control circuit coupled to each of the plurality of adjustable elements and configured to responsive to receiving a command to operate the primary power amplifier stage in a first mode, command at least one of the plurality of adjustable elements to change operation based on information in a LUT and responsive to receiving a second command to operate the primary power amplifier stage in a different mode, command the at least one of the plurality of adjustable elements to change operation.

### BRIEF DESCRIPTION OF THE DRAWINGS

Figure 1A is a block diagram of a wireless communication device having a single transceiver path;
Figure 1B is a block diagram of a wireless communication device having a plurality of transceiver paths, each with its own antenna;
Figure 1C is a block diagram of a wireless communication device having a plurality of transceiver paths, which collectively share an antenna;
Figure 2A is a block diagram of a conventional front-end module (FEM) having multiple transmission paths, each having its own power amplifier circuitry spread across multiple modules;
Figure 2B is a block diagram of a different conventional FEM having multiple transmission paths, each having its own power amplifier circuitry with the multiple paths consolidated into a single module;
Figure 3A is a block diagram of the multigenerational FEM according to an example aspect of the present disclosure where a 2G transmission path is merged into a 3G transmission path;
Figure 3B is a block diagram of a multigenerational FEM according to an example aspect of the present disclosure where a 2G transmission path is merged into an E-UTRAN New Radio - Dual Connectivity (EDNC) transmission path;
Figure 4 is a block diagram of a multigenerational FEM with additional details about tunable, adjustable, and reconfigurable elements therein that allow the operation of the merged transmission path in the various generations;
Figure 5 is a graph showing where a direct current to direct current (DC-DC) power supply transitions between buck and boost modes relative to various generational technology power requirements;
Figure 6A is a block diagram of a dual power management integrated circuit (PMIC) that may be used to provide combined boosted power to an ENDC merged power amplifier according to an example aspect of the present disclosure;
Figure 6B is a block diagram of the dual PMIC of Figure 6A being used to provide combined boosted power to a multigenerational merged power amplifier according to an example aspect of the present disclosure;
Figure 7 is a block diagram of a FEM with a multigenerational merged power amplifier according to the present disclosure with adjustable support elements having settings pulled from a local look-up table (LUT);
Figure 8 is a graph showing input capacitance for a power amplifier as a function of input voltage with various operating classes noted;
Figure 9A is a circuit diagram of a field effect transistor (FET) based power amplifier with a variable capacitor added to offset variations in input capacitance created as a function of operating class;
Figure 9B is a circuit diagram of a bipolar-based power amplifier with a variable capacitor added to offset variations in input capacitance created as a function of operating class;
Figure 10 is a block diagram showing a transmission path in a FEM with a variety of adjustments being available at any of the amplifying stages;
Figure 11 is a block diagram showing how additional components of a Vramp 2G device may be accommodated in the merged power amplifier techniques of the present disclosure;
Figures 12 and 13 show additional details about bias circuits that may be used to reconfigure the multigenerational power amplifier of the present disclosure;
Figure 14 is a flowchart illustrating a method for operating a multigenerational transmission path according to aspects of the present disclosure;
Figure 15A is a block diagram of a primary amplifier stage with a silicon prestage and a silicon poststage to enable some of the adjustments and tunability to provide multigenerational capability with a buck-boost direct current-to-direct current (DC-DC) converter that provides supply voltages for all stages;
Figure 15B is a block diagram similar to Figure 15A but with a bypass for the DC-DC converter to provide battery voltages directly for some modes of operation;
Figure 16 is a block diagram of the prestage of Figure 15A or 15B with additional details about the tunability features;
Figure 17 is a block diagram of the prestage of Figure 16 with a power detection capability to control biases in the primary stage for protection functionality;
Figure 18 is a block diagram of the prestage and poststage elements with power protection loops operative;
Figure 19 is a block diagram of the prestage of Figure 16 with additional overcurrent protection circuitry;
Figure 20 is a block diagram of an analog predistortion (APD) circuit in the poststage;
Figure 21 is a block diagram of an additional APD circuit implemented across the prestage and the poststage; and
Figure 22 is a block diagram of a mobile communication device that may include the multigenerational power amplifier disclosed herein.

### DETAILED DESCRIPTION

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that although the terms first, second, etc. may be used herein to describe various elements, these elements should not be limited by these terms. These terms are only used to distinguish one element from another. For example, a first element could be termed a second element, and similarly, a second element could be termed a first element without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element, or intervening elements may also be present. In contrast, when an element is referred to as being "directly on" or extending "directly onto" another element, no intervening elements are present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, no intervening elements are present. It will also be understood that when an element is referred to as being "connected" or "coupled" to another element, it can be directly connected or coupled to the other element, or intervening elements may be present. In contrast, when an element is referred to as being "directly connected" or "directly coupled" to another element, no intervening elements are present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

In keeping with the above admonition about definitions, the present disclosure defines "transceiver." Current industry literature uses the term "transceiver" in two primary ways. In a first meaning, the term refers broadly to a plurality of circuits that send and receive signals. In this broader context, example circuits may include a baseband processor, an up/down conversion circuit, filters, amplifiers, couplers, and the like coupled to one or more antennas. In contrast, in the second meaning, some authors in the industry literature refer specifically to a circuit positioned between a baseband processor and a power amplifier circuit as a transceiver. This intermediate circuit may include the up/down conversion circuits, mixers, oscillators, filters, and the like, but generally does not include the power amplifiers. As used herein, the term transceiver is used in the first sense. Where relevant to distinguish between the two definitions, the terms "transceiver chain" and "transceiver circuit" are used respectively.

Further, as used herein, approximately means within five percent (5%).

ENDC is a multilayer acronym with multiple layers of embedded acronyms whose explication interrupts the flow of normal prose. Rather than try to work the explanation into normal prose, the expansion of this acronym is set forth here for simplicity. Specifically, ENDC stands for E-UTRAN New Radio - Dual Connectivity, where E-UTRAN stands for Evolved Universal Terrestrial Radio Access Network or sometimes Evolved UMTS Terrestrial Radio Access Network, where UMTS stands for Universal Mobile Telecommunications Service.

Aspects disclosed in the detailed description include a multigenerational front-end module (FEM). In particular, a FEM having a single transmission path may include a single power amplifier with supporting elements such as for example, bias levels, load modulation, supply voltages, or the like, that may be reconfigured and tuned so as to allow the single power amplifier to adjust effectively and work with different generations of wireless protocols. The use of such an adjustable, reconfigurable, tunable transmission path allows smaller and more cost-effective FEM to be provided. Settings for the various changes may be stored in a look-up table (LUT) or the like.

In further aspects, much of the tuning and adjustments used to switch between generations may be implemented in a silicon stage that is positioned before a primary amplifier stage that is formed in a different material (e.g., gallium arsenide (GaAs)) along with a second silicon stage that is positioned after the primary amplifier stage. The use of silicon around the primary stage allows for easier implementation of certain features as well as enabling more readily implemented protection loops and/or analog predistortion circuitry.

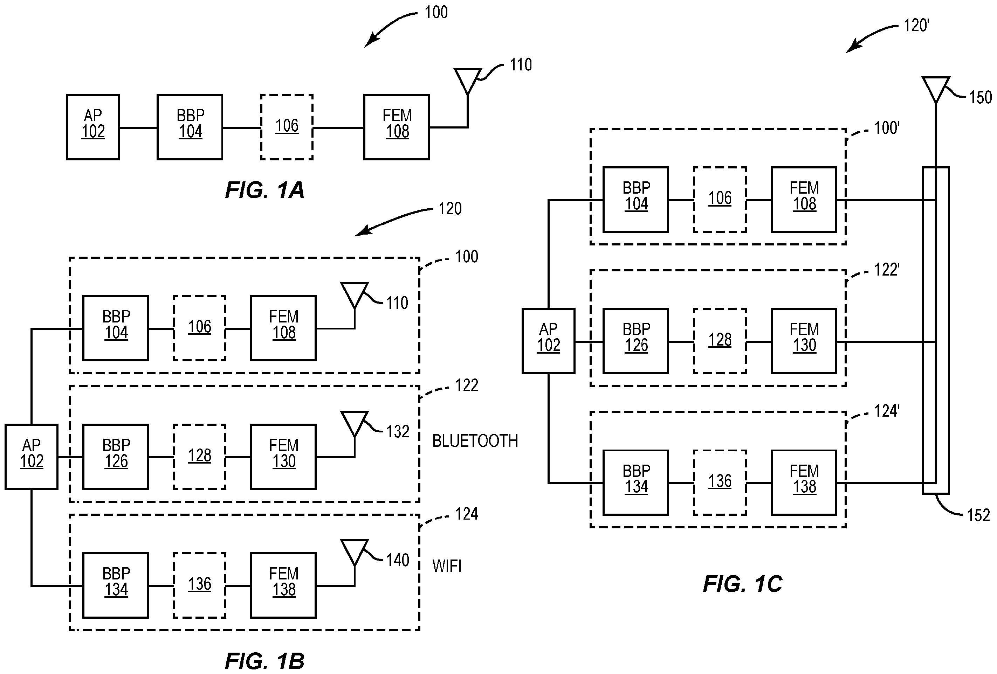

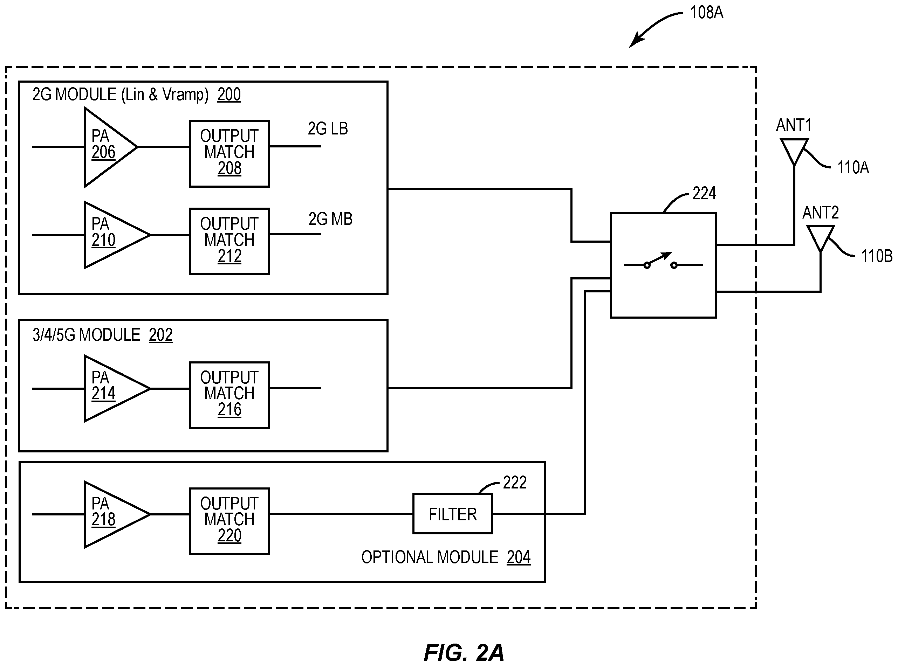

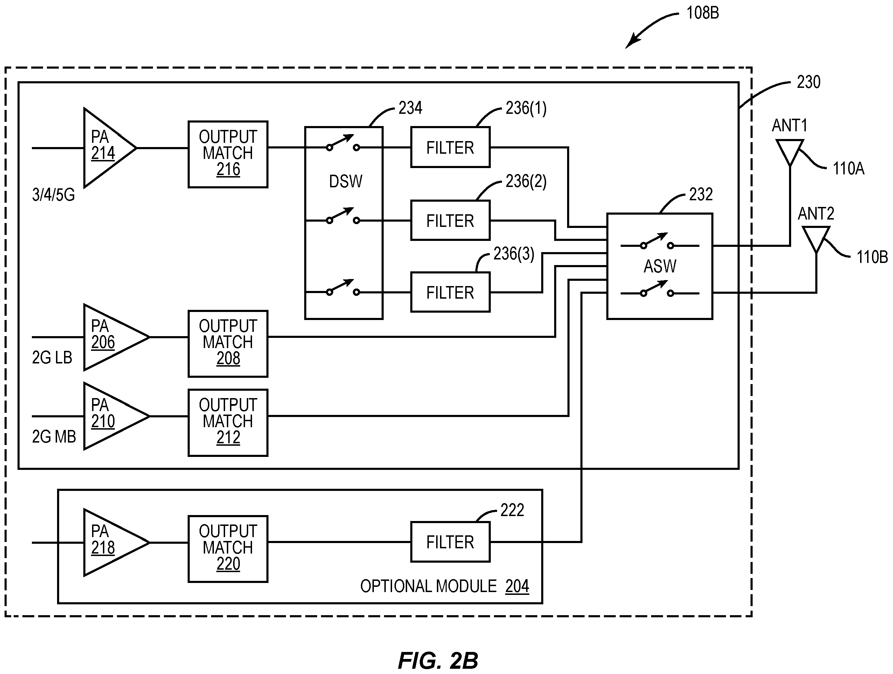

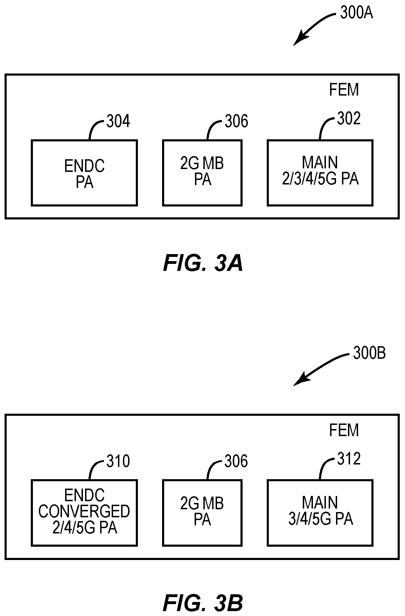

Before addressing example aspects of the present disclosure, a discussion of parts of a transmission path in a transceiver is provided with reference to Figure 1A. A discussion of a device having a plurality of transmission paths follows with respect to Figures 1B and 1C. Figures 2A and 2B illustrate various possible FEMs that are designed to accommodate the plurality of transmission paths to help illustrate some of the challenges of conventional mobile communication devices. Aspects of the present disclosure consolidate transmission paths in a FEM, and the discussion of these aspects begins below with reference to Figure 3A.

In this regard, Figure 1A illustrates a first transmission path 100 that may begin in an application processor (AP) 102. Data generated in the AP 102 is passed to a baseband processor (BBP) 104 and formatted into a signal for transmission. The signal for transmission may optionally be upconverted and conditioned by a transceiver circuit 106. The signal then goes to a FEM 108 and then is radiated out through an antenna 110.

While Figure 1A illustrates a simple transmission path 100, many mobile computing devices have multiple transmission paths for different wireless protocols. Thus, as illustrated in Figure 1B, a mobile computing device 120 may include the first transmission path 100 as well as a BLUETOOTH transmission path 122 and a WIFI transmission path 124. The BLUETOOTH transmission path 122 is coupled to the AP 102 and includes a BBP 126, an optional transceiver circuit 128, a FEM 130, and an antenna 132. The BLUETOOTH transmission path 122 is configured to prepare and send signals complying with the BLUETOOTH protocol. Similarly, the WIFI transmission path 124 is coupled to the AP 102 and includes a BBP 134, an optional transceiver circuit 136, a FEM 138, and an antenna 140. The WIFI transmission path 124 is configured to prepare and send signals complying with the WIF protocol. While not shown, there may be transmission paths for other wireless protocols in the mobile computing device 120.

As a routinely contemplated variation, antennas may be shared across transmission paths. Thus, as shown in Figure 1C, a shared antenna 150 may be provided for the mobile computing device 120'. A multiplexer or switch 152 may route signals from transmission paths 100', 122', and 124' to the antenna 150.

In many cases, there is duplication of BBP, transceiver circuits, and FEMs for the various wireless protocols within a mobile computing device. However, given the different requirements, such duplication is frequently accepted.

The problem of duplication is even greater when a typical FEM that supports multiple generations of wireless protocols is considered. In particular, as of this writing, 2G-5G protocols are still active and supported in many mobile computing devices. While 6G is, as of this writing, still in the planning stages, the fact that committees are meeting to define its requirements indicates that 6G is a certainty in time. It is not expected that the advent of 6G will eliminate use of any of the earlier generations. The conventional approach is to have separate power amplifier paths that serve different wireless protocols.

In this regard, Figure 2A illustrates a conventional FEM 108A (that may take the place of FEM 108 in a conventional mobile computing device) that may include a 2G module 200, a linear late generation module 202, and an optional ENDC module 204. The 2G module 200 may include a first low bandwidth power amplifier 206 with a first low bandwidth output match circuit 208, a second medium bandwidth power amplifier 210, and a second medium bandwidth output match circuit 212. The 2G module 200 may serve to amplify and condition signals complying with 2G cellular protocols. It should be appreciated that 2G protocols may operate both in a linear mode (Lin) as well as a Vramp mode.

With continued reference to Figure 2A, the linear late generation module 202 may include a third power amplifier 214 and a third output match circuit 216. In many regards, the second medium bandwidth power amplifier 210 and the third power amplifier 214 are duplicative. Likewise, the second medium bandwidth output match circuit 212 and the third output match circuit 216 are duplicative. The linear late generation module 202 may serve to amplify and condition signals complying with 3G, 4G, and/or 5G cellular protocols.

With continued reference to Figure 2A, the ENDC module 204 may include a fourth power amplifier 218, a fourth output match circuit 220, and a filter 222. In many regards, the fourth power amplifier is duplicative relative to the second medium bandwidth power amplifier 210 and the third power amplifier 214. Likewise, the fourth output match circuit 220 is duplicative relative to the second medium bandwidth output match circuit 212 and the third output match circuit 216. The ENDC module 204 may be used to provide a second signal path in a desired protocol (usually 4G) that is used for carrier aggregation.

The various modules 200, 202, and 204 are coupled to the antenna 110A (and optionally antenna 110B) through a multiplexer or switch 224. The antenna 110B may be provided to assist in carrier aggregation or diversity transmission as is well understood. Likewise, the antennas 110A, 110B may be antenna arrays able to do beam steering, as is well understood. In some implementations, the switch 224 may be within one of the modules. The modules 200, 202, and 204 may be encapsulated in a unitary mold compound so that the FEM 108A may be sold as a single unit. Alternatively, and not shown, the module 204 may be in a separate device (e.g., on a different substrate outside the encapsulation of the modules 200 and 202).

There are conventional implementations that combine the modules 200 and 202 into a single module, but such implementations still retain duplicative elements. Such an implementation is illustrated by FEM 108B in Figure 2B. The FEM 108B may include the ENDC module 204, as previously described, as well as a combined module 230. The combined module 230 includes a first low bandwidth power amplifier 206 with a first low bandwidth output match circuit 208 and a second medium bandwidth power amplifier 210, and a second medium bandwidth output match circuit 212. The combined module 230 also includes a third power amplifier 214 and a third output match circuit 216. An antenna switch 232 may couple the different paths to the antennas 110A, 110B. Likewise, a switch 234 may couple the output match circuit 216 to different filters 236(1)-236(3). The filters 236(1)-236(3) may be optimized for a given one of the later linear generations (i.e., 3G-5G). As noted above, in many instances, the power amplifiers are duplicative as are the output match circuits.

The duplication of the power amplifiers and the output match circuits increases the overall cost of the FEM as well as makes the FEM larger. Both increased cost and increased size are commercially undesirable. Further, having duplicative circuits may increase leakage current, which may incrementally increase power consumption. Likewise, having multiple paths means more conductors coming into the FEM with appurtenant routing issues, which may further exacerbate the size issues.

Example aspects of the present disclosure consolidate at least the linear portion of the 2G path with the later linear generation paths. Because of the different bandwidths, power requirements, class of operation, and the like, such consolidation requires flexibility in other elements of the FEM. The following Figures explore some of the various ways to make the FEM adaptable, tunable, and reconfigurable.

In this regard, Figure 3A illustrates a first FEM 300A, where the linear 2G path is consolidated into the linear later generation path, that is, into a multigenerational main power amplifier 302. An ENDC path with an ENDC power amplifier 304 and a 2G medium bandwidth path with a 2G amplifier 306 (sometimes also referred to as Vramp) remain distinct paths with their own power amplifiers and supporting circuitry. Similarly, Figure 3B illustrates a second FEM 300B where the linear 2G path is consolidated into the ENDC path to form a multigenerational power amplifier 310. The linear later generation path with basic multigenerational power amplifier 312 (perhaps limited to just 3G-5G) and the 2G medium bandwidth path with the 2G amplifier 306 remain distinct paths with their own power amplifiers and supporting circuitry. Elimination of the low bandwidth path and consolidation of power amplifier elements and output match circuit elements reduces the overall size of the FEM as well as reduces the cost of the FEM. Note that optionally the 2G Vramp may also be integrated into the consolidated path. While other elements of the FEM will be made tunable or reconfigurable to adapt to the operating mode, the overall effect retains cost savings and space reduction. The following Figures explore the details of the changes to the other elements.

While the following Figures are generally generic as to whether the multigenerational FEM is the main FEM or the ENDC FEM, it should be appreciated that the discussion is equally applicable to both unless otherwise indicated. Likewise, while a given amplifier may seemingly be described as a single amplifier, any given amplifier may be formed from multiple stages or multiple stacked transistors (e.g., cascoded). Likewise, it should be appreciated that the amplifiers may be bipolar junction transistors (BJT) or field effect transistors (FETs).

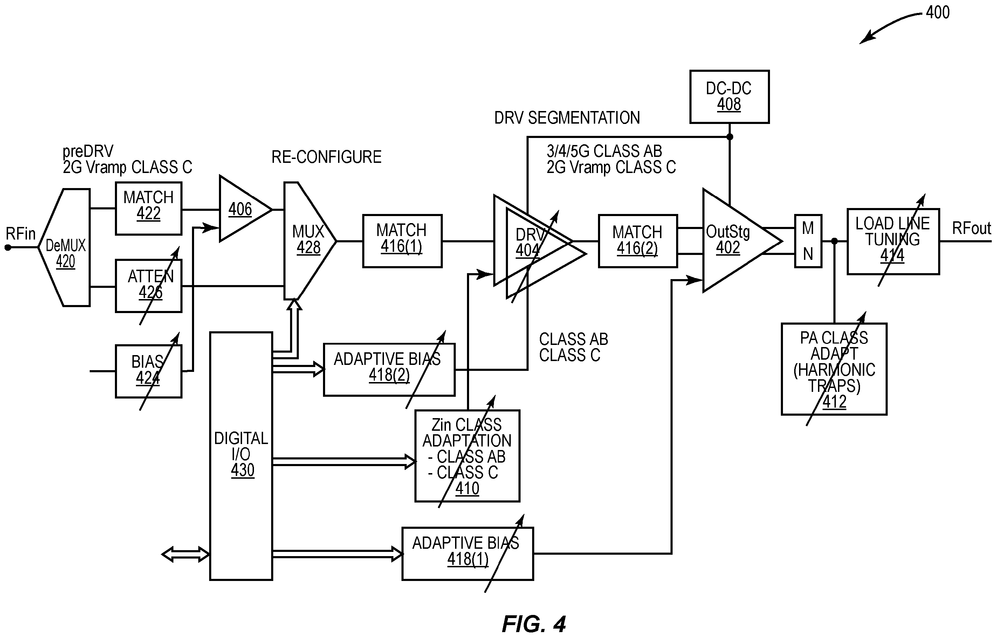

In this regard, Figure 4 illustrates a FEM 400 (which may be either FEM 300A or 300B) that highlights the changes to the supporting elements to make the power amplifier 402 able to provide desired amplification to a signal in any of the 2G-5G (and subsequent generations) cellular standards. It should be appreciated that the different modes of operation need rather different maximum power levels, gain, and class of operation, as well as a requirement for predictable operation in different frequency bands and differently sized signal bandwidths.

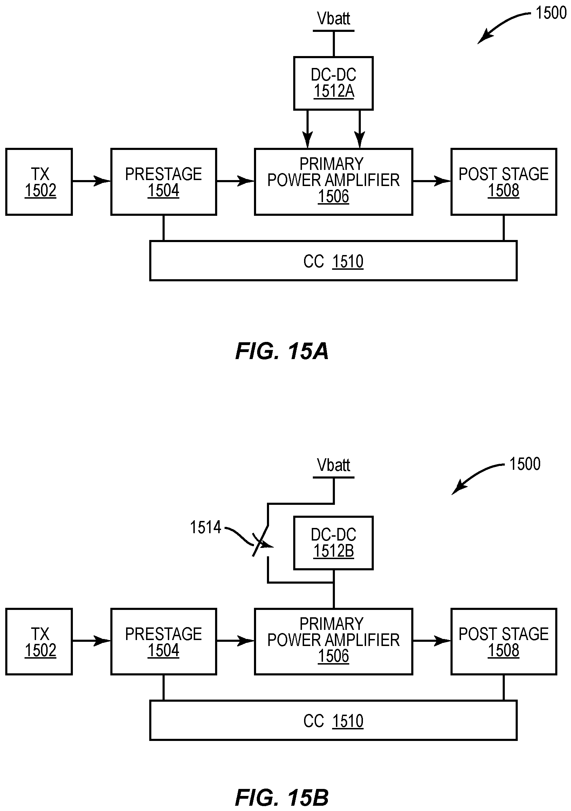

The 2G modes typically require larger output power and larger path gains than other modes. Accordingly, a driver amplifier 404 may be present for 3G, 4G, and 5G modes and a predriver amplifier 406 for 2G modes. Additionally, a hybrid silicon complementary metal oxide semiconductor (CMOS)-gallium arsenide (GaAs) power amplifier 402 (and likely driver amplifier 404) may make for easier implementation because reconfiguration of certain types is generally easier in CMOS structures. It should be noted that other types of reconfigurations may be better done in silicon, as better explained beginning below with reference to Figure 15A.

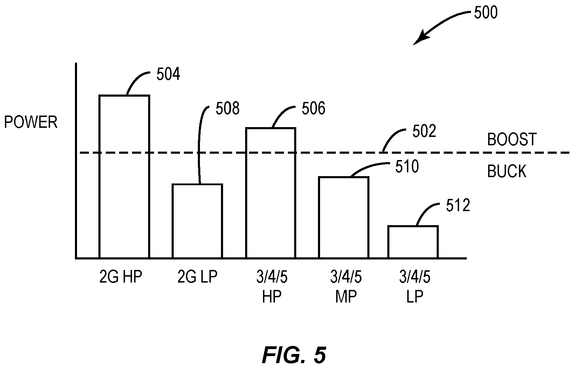

A PMIC 408 provides a supply voltage to the power amplifier 402. The PMIC 408 may be a buck-boost DC-DC converter that changes between a boost mode for 2G and high power 3G-5G modes and a buck mode for most low and mid-power modes. A more in-depth discussion of the PMIC 408 is provided below in Figures 5-6B.

Furthermore, the different modes may need different classes of operation (e.g., A, AB, B, C, F, inverted F, etc.) of the power amplifier 402. For example, 3G-5G may use class AB for the power amplifier 402 and the driver amplifier 404, while the 2G Vramp may use class C operation. Such different classes of operation may result in widely different input impedances for the stage. An impedance adaptation circuit 410 may be provided to compensate for impedance variation of the active stage. Also, a harmonic trap circuit 412 may be used at an output of the power amplifier 402 to assist in adapting to the different classes of operation.

Another adaptation is the use of an adaptable load line tuning circuit 414. It should be appreciated that since this occurs at the output of the power amplifier 402, switching the load line impedance involves some efficiency loss. This efficiency loss makes wide-range load impedance tuning less attractive, but it remains an option to assist in providing the multigenerational power amplifier of the present disclosure.

Matching circuits 416(1) and 416(2) may provide impedance matching or the like and may if desired, be configurable to assist in conditioning a signal for amplification or the like.

Adjustable bias circuits 418(1) and 418(2) may control the bias for the power amplifier 402 and the driver amplifier 404, respectively. By making these bias values adjustable, the operation of the amplifiers may be tailored to the desired mode.

To assist in handling the 2G mode, an input signal (RFin) may be demultiplexed (DeMUX) by a demultiplexer 420. 2G signals may pass through a match circuit 422 and then to the predriver amplifier 406. An adjustable bias circuit 424 may bias the predriver amplifier 406. The adaption of the adjustable bias circuit 424 may be somewhat constrained because the predriver amplifier 406 is only switching between 2G Vramp and linear 2G.

3G-5G signals pass through the demultiplexer 420 and may be variably attenuated by variable attenuator 426. The 2G-5G paths are recombined by a multiplexer (MUX) 428 before going to the matching circuit 416(1) and the main consolidated transmission path.

Knowing what mode is active so that the adjustments can be made may come from information provided by the BBP (not shown in Figure 4) through a bus interface 430 (also referred to as a digital input/output (I/O)) and an associated control circuit (not shown).

While Figure 4 shows some of the possible tuning and adaptations that may be made to accommodate the multigenerational demands, the details are numerous. Figure 5 illustrates a bar graph 500, which shows the various modes and their power requirements. Line 502 shows an abstract representation of where the DC-DC converter switches between buck to boost modes. Thus, the 2G high power column 504 and high-power later generation column 506 are boost modes and the remaining columns (i.e., 2G low power column 508, later generation midpower column 510 and later generation low power column 512) are all buck mode power requirements.

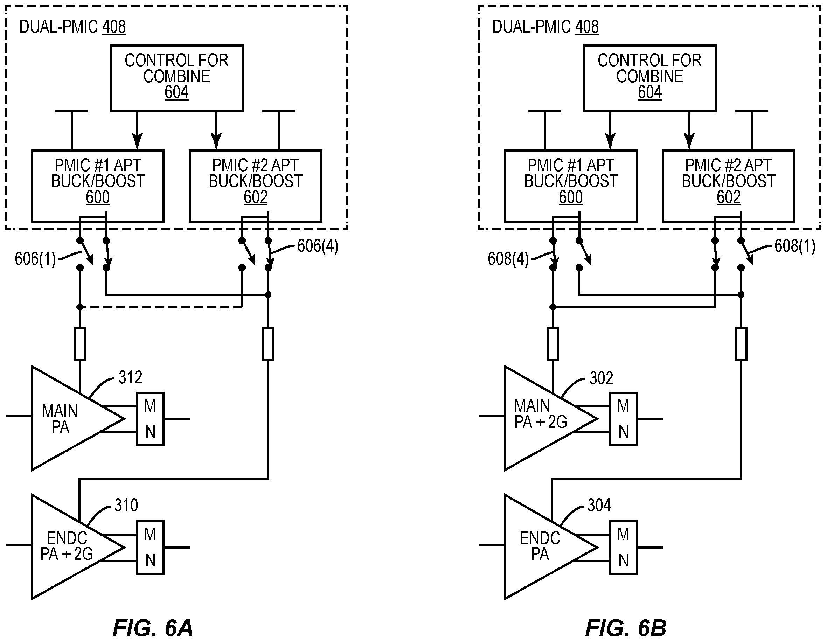

Because the power requirements for high-power 2G are so much greater than the power requirements for other modes, the present disclosure contemplates a special PMIC 408, as better illustrated in Figures 6A and 6B. Specifically, the PMIC 408 has a first buck-boost DC-DC converter 600 and a second buck-boost DC-DC converter 602, along with a control circuit 604. The control circuit 604 controls how and when the outputs of the DC-DC converters 600 and 602 are combined. Thus, for example, switches 606(1)-606(4) may be controlled by the control circuit 604 to direct a combined power signal to a multigenerational power amplifier 310, or a single switch 606(1) may provide a single power signal to the basic multigenerational power amplifier 312 as shown in Figure 6A. Alternatively, as shown in Figure 6B, switches 608(1)-608(4) may provide a combined power signal to the multigenerational main power amplifier 302, and a single switch 608(1) may provide a single power signal to the ENDC power amplifier 304.

As intimated above, there are many elements which may be adjusted based on which generational mode is being used. A local control circuit in the FEM may provide instructions to each element by writing appropriate values into a corresponding setting register (not shown) after retrieving such values from a local memory (e.g., a LUT). While, in theory, the local control circuit could calculate these values dynamically, current commercial constraints on the size and power of the control circuit preclude such an approach, and a local LUT is more practical. Likewise, the BBP 104 could send values over the communication bus to the FEM. These values could be stored in memory (e.g., in a LUT) in the BBP 104 or calculated dynamically. However, the current communication bus under the current MIPI standard is a fairly narrow band channel, and the volume of settings would likely exceed the bandwidth capacity of the bus under the current MIPI standard.

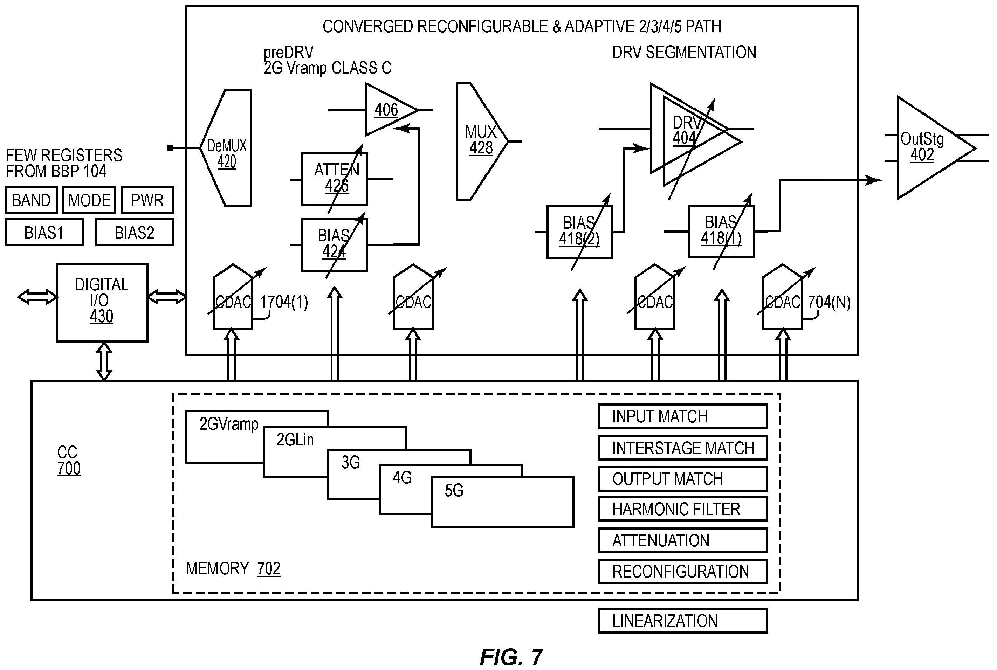

Accordingly, as illustrated in Figure 7, example aspects of the present disclosure contemplate a local control circuit 700 using a local memory 702 (which may be read-only memory (ROM)) to store settings for per mode optimization. In an example aspect, these settings are stored in a LUT. Such LUT may be a multipage LUT and store information such as settings for an input match circuit, an interstage match circuit, an output match circuit, a harmonic filter, attenuation settings, reconfiguration, class settings, linearization, analog predistortion, and the like. Even with such a local LUT, some settings may still come from the BBP 104, such as the band, mode, power level, bias settings, or the like. To facilitate the use of such settings, some of the adjustable elements may be formed in CMOS structures and may be controlled through a corresponding digital to analog (DAC) 704(1)-704(N).

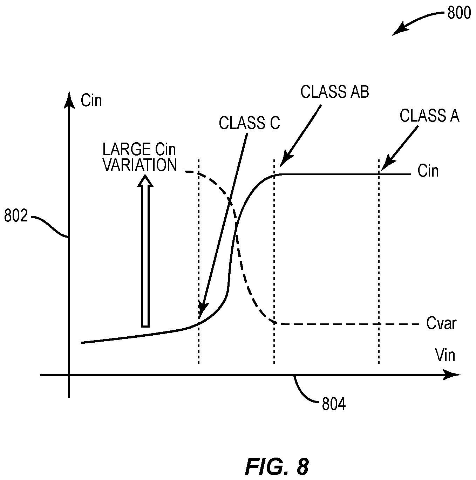

As noted above, one feature of reconfiguration is the class of operation for each of the power amplifiers. When the operation class changes, the input impedance of the power amplifier changes, as better illustrated in Figure 8. Specifically, Figure 8 illustrates a graph 800 showing how capacitance on y-axis 802 varies as a function of input voltage on x-axis 804. While class A and class C operations are fairly stable, class AB has a large capacitance variation.

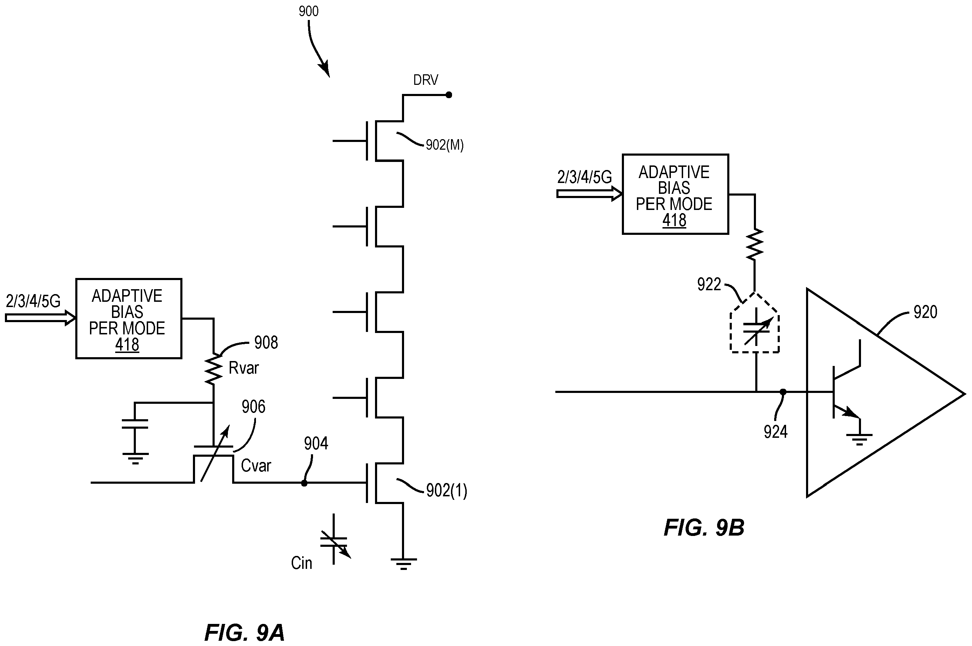

To compensate for such possible capacitive input variation, aspects of the present disclosure may include a tunable capacitive element at an input to a power amplifier as better seen in Figures 9A and 9B. Thus, for example, for a CMOS power amplifier 900 formed from a stack of cascoded FETs 902(1)-902(M), an input 904 may receive a bias signal from an adjustable bias circuit 418 as well as have this bias signal pass through a tunable capacitance circuit 906 and a variable resistor 908. The tunable capacitance circuit 906 may be programmed by DAC (not shown) to sum with the input capacitance of the power amplifier 900 to provide a constant total input capacitance.

Similarly, for a bipolar power amplifier 920, illustrated in Figure 9B, a tunable capacitance circuit 922 may be provided between the adjustable bias circuit 418 and the input 924 of the power amplifier 920. Still, other arrangements are possible without departing from the present disclosure.

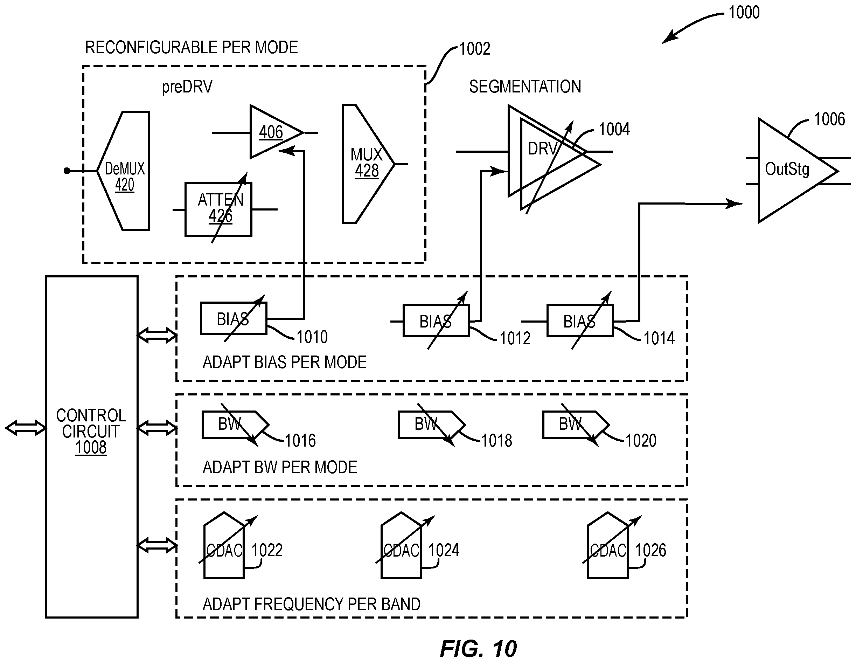

To the extent it was not explicitly clear above, it should be appreciated that tuning and reconfiguration may be done at each amplifier stage as better illustrated in Figure 10. In this regard, Figure 10 illustrates a FEM 1000 having a predriver amplifier 1002, a driver amplifier 1004, and a main power amplifier 1006. A control circuit 1008 may provide settings for setting registers (not shown explicitly) for a first bias circuit 1010 that biases the predriver amplifier 1002, a second bias circuit 1012 that biases the driver amplifier 1004, and a third bias circuit 1014 that biases the main power amplifier 1006. Further, the control circuit 1008 may adapt a bandwidth for each amplifier 1002, 1004, 1006 using bandwidth adjustment circuits 1016, 1018, and 1020 respectively. Still further, the control circuit 1008 may adapt frequency per band using DACs 1022, 1024, and 1026 for amplifiers 1002, 1004, and 1006 respectively.

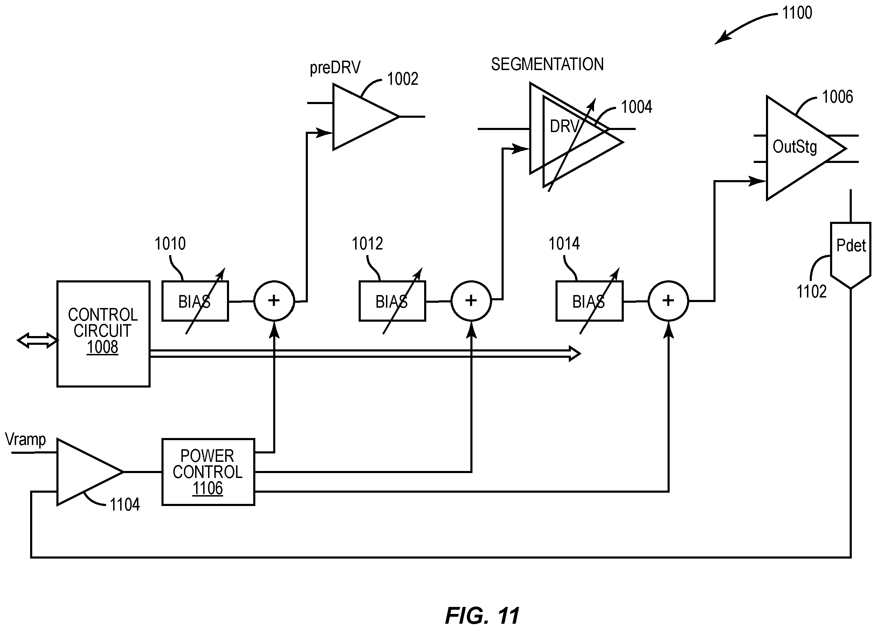

Where the 2G Vramp is also included in the multigenerational power amplifier, it may be appropriate to provide a closed loop bias, as better seen in Figure 11, where a FEM 1100 has power amplifiers 1002, 1004, and 1006 along with bias circuits 1010, 1012, and 1014, as previously described as well as other components described above, but not replicated for simplicity. A power detector 1102 may be present at an output of the power amplifier 1006 and provide a feedback signal to a Vramp amplifier 1104 and power control circuit 1106. The signals from the power control circuit 1106 may be combined with the bias signals for each of the power amplifiers 1002, 1004, and 1006. Note that the signals need not be uniform.

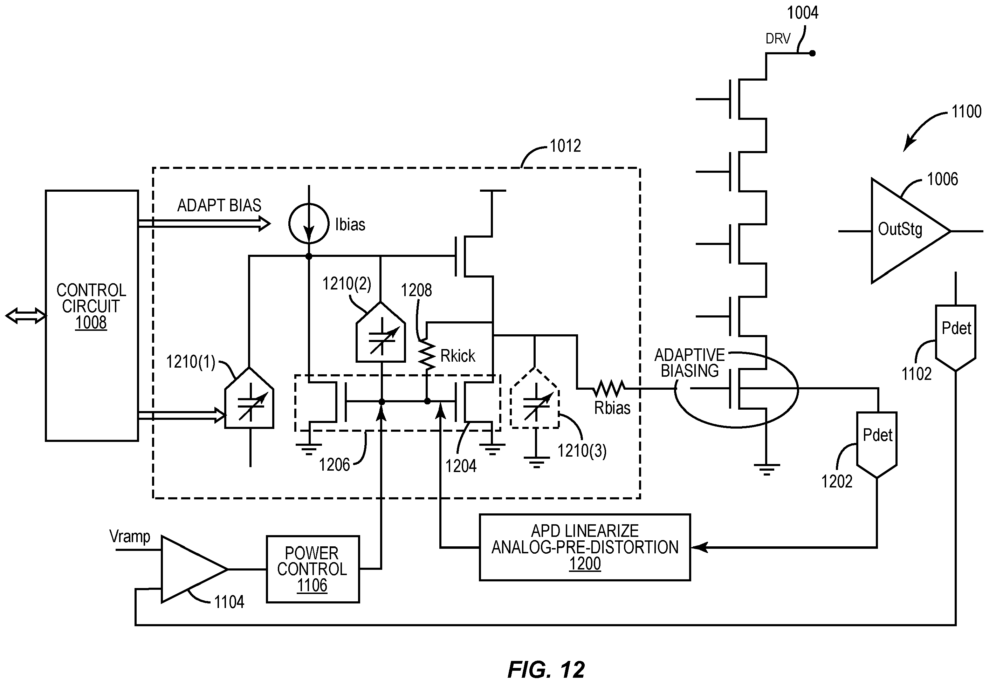

As alluded to above, analog pre-distortion may also be used with aspects of the present disclosure. Figure 12 illustrates an analog-pre-distribution (APD) circuit 1200 used with the FEM 1100. A power detector 1202 senses power in the driver amplifier 1004 and may provide a signal to the adaptive bias circuit 1012. Figure 12 also provides additional details about a possible circuit for the bias circuit 1012. Specifically, the bias circuit 1012 may be a form of open loop bias and is given by a diode connected FET 1204 in mirror 1206. If no current is injected into the kick resistor 1208, the bias voltage (Vbias) is equal to the Vgs of the diode connected FET 1204. When in the 2G Vramp mode, a current is injected into the kick resistor 1208, and Vbias = Vgs + I*Rkick. Modulating the current injected into the kick resistor 1208 can be adjusted to close the power control loop. The kick resistor 1208 may also be used to help linearize the amplitude modulation-amplitude modulation (AM-AM) APD by the APD circuit 1200.

In 2G, the noise specification is challenging, and the signal bandwidth is low. To assist in meeting the noise requirement, the bandwidth of the bias circuit 1012 is reduced to limit noise up-conversion. Variable capacitors (e.g., capacitor DACs) 1210(1)-1210(3) may be used to adapt the bandwidth of the bias and reduce the noise impact of the kick resistor 1208.

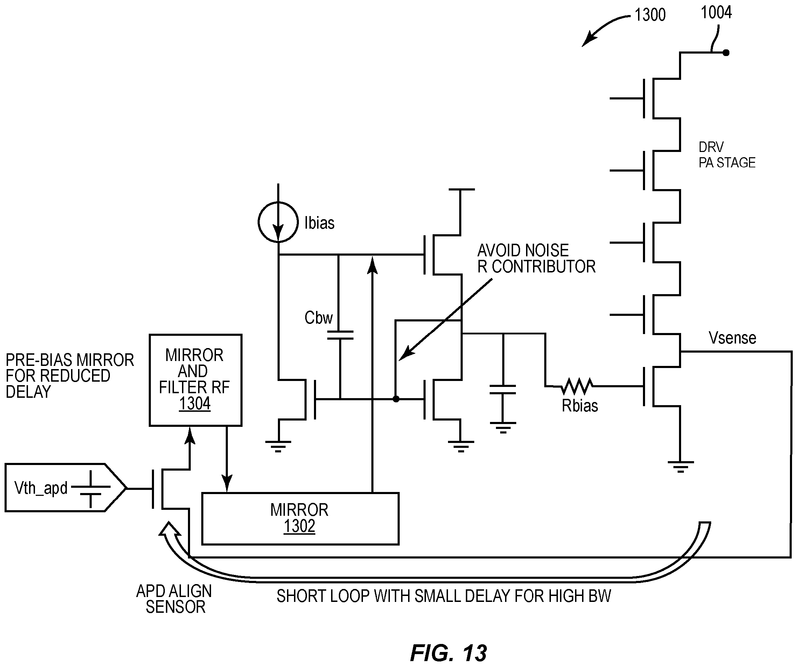

An alternate aspect of a bias circuit 1012 is provided in Figure 13. Specifically, bias circuit 1300 eliminates the kick resistor, thereby reducing the noise and reducing the need for bias bandwidth adjustment. APD and Vramp power control are done with fast mirrors 1302, 1304 in place of the kick resistor.

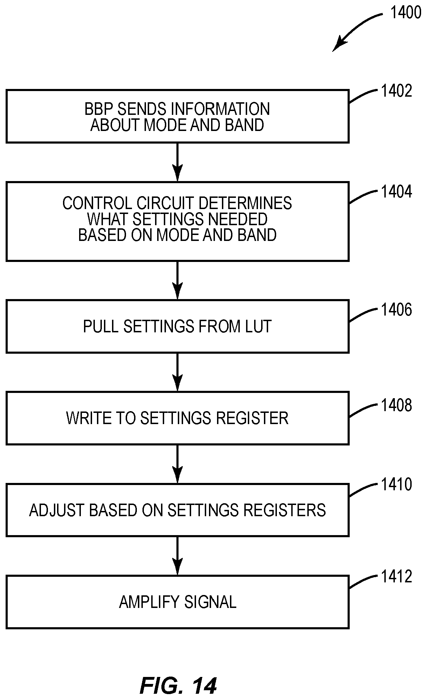

An overview of a process 1400 for using a multigenerational power amplifier is provided with reference to Figure 14. Specifically, a BBP sends information to the FEM where the information contains a mode and band (and optionally bias and/or power levels) (block 1402). The control circuit in the FEM determines what settings are needed based on the mode and band information from the BBP (block 1404). The control circuit pulls settings from the LUT (block 1406) and writes the settings to the settings registers for the adjustable elements within the FEM (block 1408). The adjustable elements do adjust based on the new settings in the settings registers (block 1410), and the signal is amplified using the new configuration (block 1412).

The above discussion assumes that it may be possible to implement the requisite functionality in any desired location. While this assumption is true, certain implementations may be more difficult than others. Likewise, there may be legacy power amplifier chips that could benefit from aspects of the present disclosure but are not readily amenable to internal changes to effectuate such functionality. Additional aspects of the present disclosure contemplate providing supporting functionality in silicon structures that may metaphorically surround such a primary amplifier chip. In particular, a primary amplifier chip may have a prestage structure that precedes an input to the driver amplifier of the primary amplifier chip and a poststage structure that follows an output of the output stage amplifier. The prestage and poststage structures may be implemented in silicon and may be part of the same physical device (e.g., same chip or module).

In this regard, Figures 15A & 15B illustrate an amplifier chain 1500 with a transceiver circuit 1502, a prestage structure 1504, a primary amplifier structure 1506, and a poststage structure 1508. In an example aspect, the primary amplifier structure 1506 is made from GaAs or the like and includes a driver amplifier (e.g., driver amplifier 404) and an output stage amplifier (e.g., the output stage amplifier - i.e., power amplifier 402). Conversely, the prestage structure 1504 and the poststage structure 1508 are made from silicon. The prestage structure 1504 may include a predriver amplifier (e.g., predriver amplifier 406) and supporting circuitry. The poststage structure 1508 may include switching networks, impedance matching circuits, filters, and the like (e.g., load line tuning circuits 414 and harmonic trap circuits 412). Additionally, a control circuit 1510 may also be implemented in silicon. The control circuit 1510 may also be co-located with bias circuitry (not shown) that works with the primary amplifier structure 1506. In one aspect, the structures 1504, 1508, and the control circuit 1510 are in the same chip, but such an arrangement is not required.

Where Figures 15A & 15B differ is in the DC-DC converters 1512A and 1512B, respectively. The DC-DC converter 1512A is a buck-boost converter that has the ability to boost the signal to the high levels required by 2G systems (e.g., the dual PMIC 408) and may directly connect to the primary amplifier structure 1506. In contrast, the DC-DC converter 1512B has a bypass switch 1514 that allows Vbatt to couple directly to the primary amplifier structure 1506 so as to provide the high power required for 2G operation.

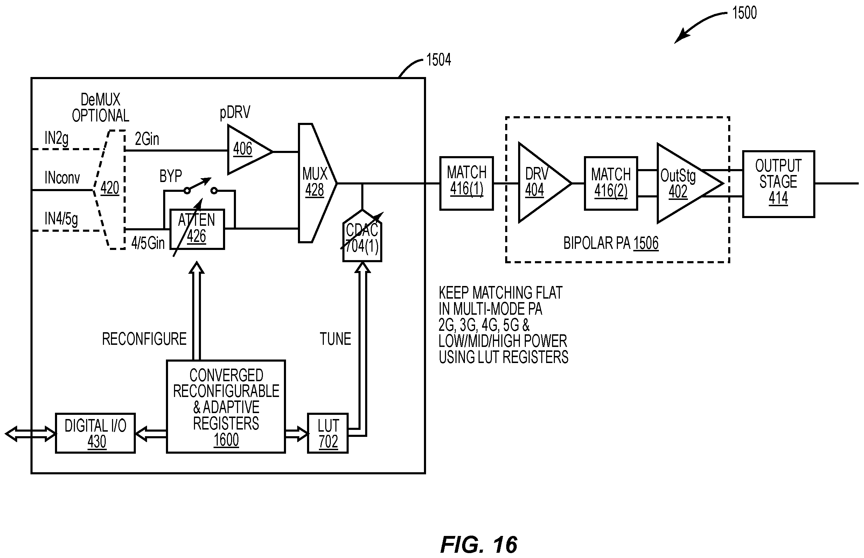

Figure 16 provides some additional details about possible ways to implement the prestage structure 1504 in which elements already discussed may be positioned in the silicon of the prestage structure 1504. In particular, signals arrive and are demultiplexed by demultiplexer 420. 2G signals may go through the predriver amplifier 406, while other signals may go through the variable attenuator 426. The signals are multiplexed by the mux 428. The variable CDACs 704(1) are used to control variations between modes at this stage. The local memory 702 and registers 1600 may be used to control the variable attenuator 426 and CDACs 704(1).

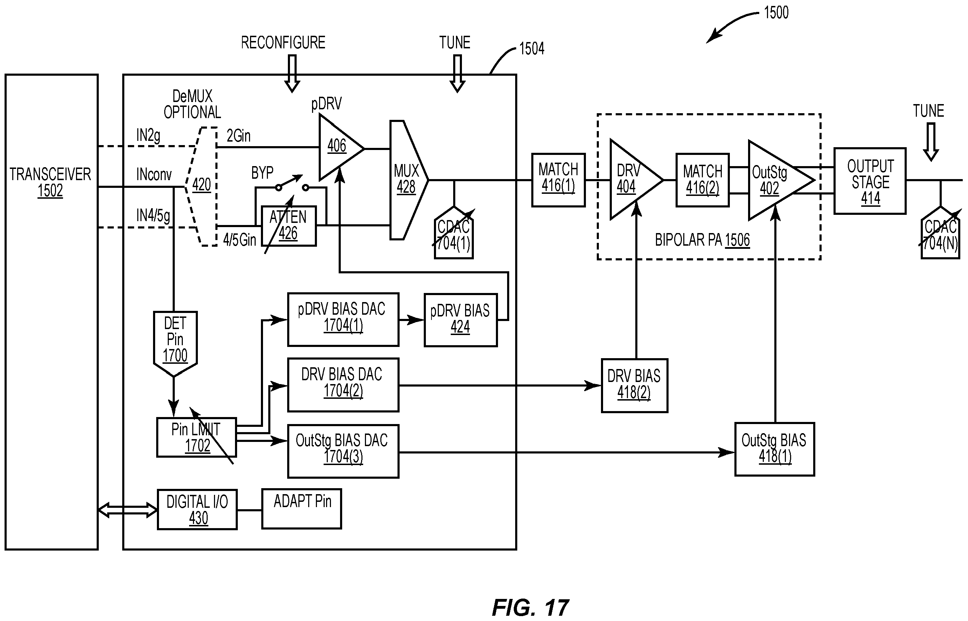

Figure 17 expands on the prestage structure 1504 showing how a power detector 1700 may detect power at the input to provide information to an input power limiter circuit 1702. The input power limiter circuit 1702 may use information about the input power to set DACs 1704(1)-1704(3) that assist in controlling the bias circuits 424, 418(1), and 418(2). This arrangement may assist in protecting the circuits from overpower conditions based on mode. That is, certain modes may need different power levels, as previously described, and the ability to control the biases to stay within the desired power level of the mode is desirable. Likewise, the input signal may vary in different ranges depending on the mode, and adapting to that input is desirable.

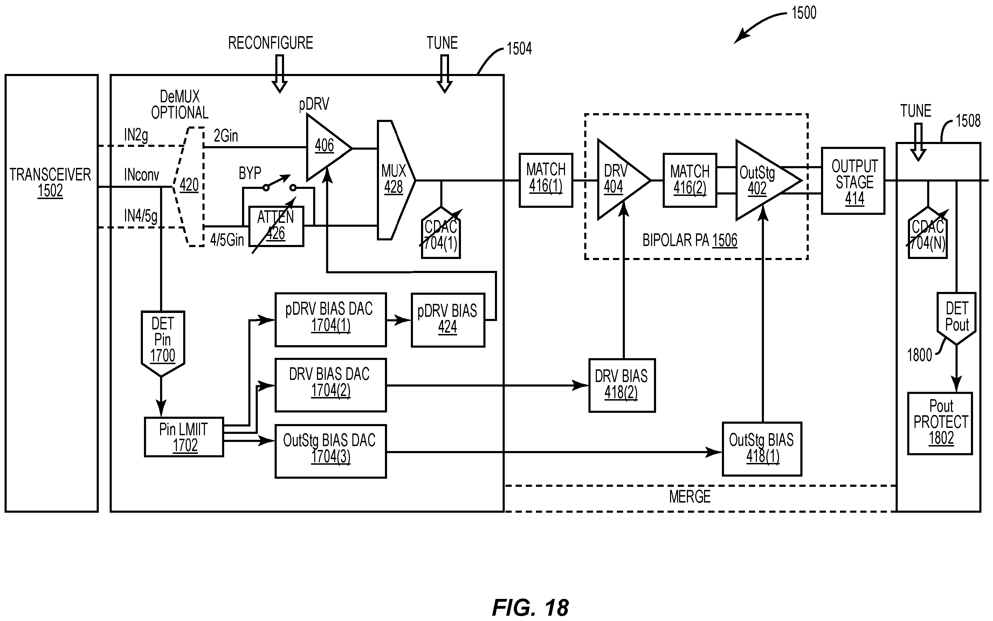

Figure 18 adds an output power detector 1800 in the poststage structure 1508, which may be used by a power protection circuit 1802 to adjust bias circuits 418(1), 418(2). Again, the various modes may require different power levels, and while the various adjustments made possible by the present disclosure contemplate dialing in the power levels to the desired levels through the adjustments, having an additional protection circuit may assist in preventing damage from overpower conditions.

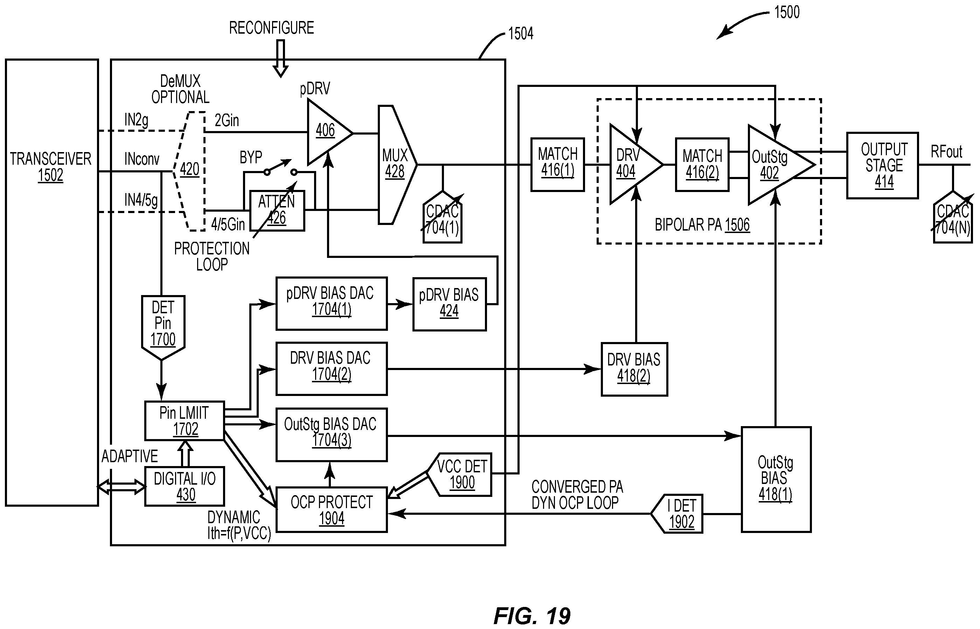

Figure 19 illustrates another option in terms of a protection circuit. More particularly, a voltage detector 1900 may snoop the supply voltages supplied to the driver amplifier 404 and/or the power amplifier 402. A current detector 1902 may detect a bias current provided to the power amplifier 402. This information may then be provided to an overcurrent protection circuit 1904, which with information from the power detector 1700 and the output power detector 1800, may determine when an overcurrent condition exists and adjust one or more bias circuits, such as the output bias circuit 418(1).

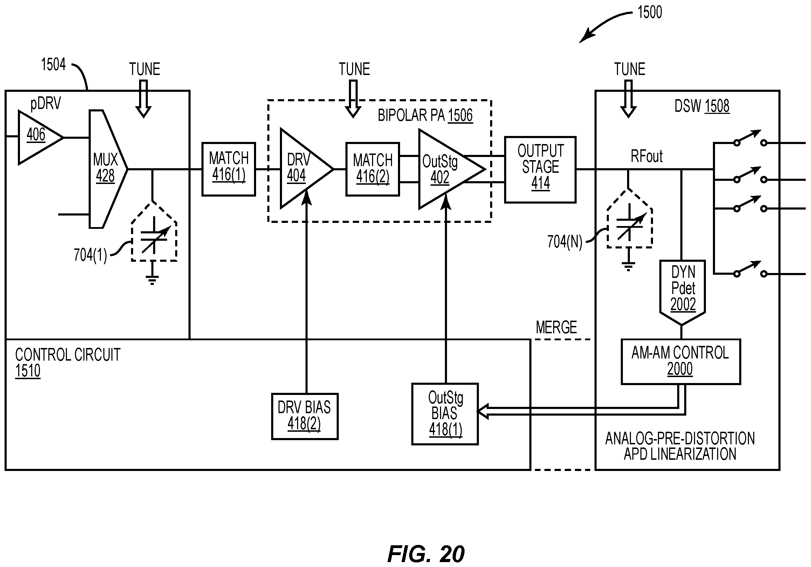

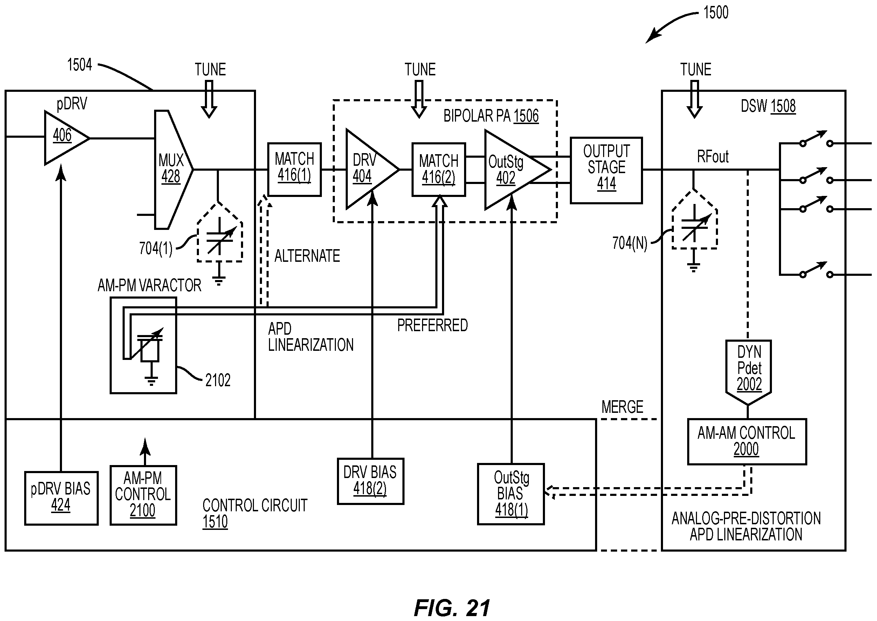

Figures 20 and 21 illustrate possible details for an APD scheme. In particular, Figure 20 illustrates an AM-AM APD circuit 2000 that uses a power detector 2002 in the poststage structure 1508 to determine an adjustment to the output stage bias circuit 418(1). It should be noted that the bias circuits 418(1) and 418(2) may be within the control circuit 1510.

Figure 21 adds an AM-PM APD circuit 2100 that receives information about a phase distortion and uses a variable capacitor 2102 to inject phase predistortion either at the interstage matching circuit 416(1) or the interstage matching circuit 416(2).

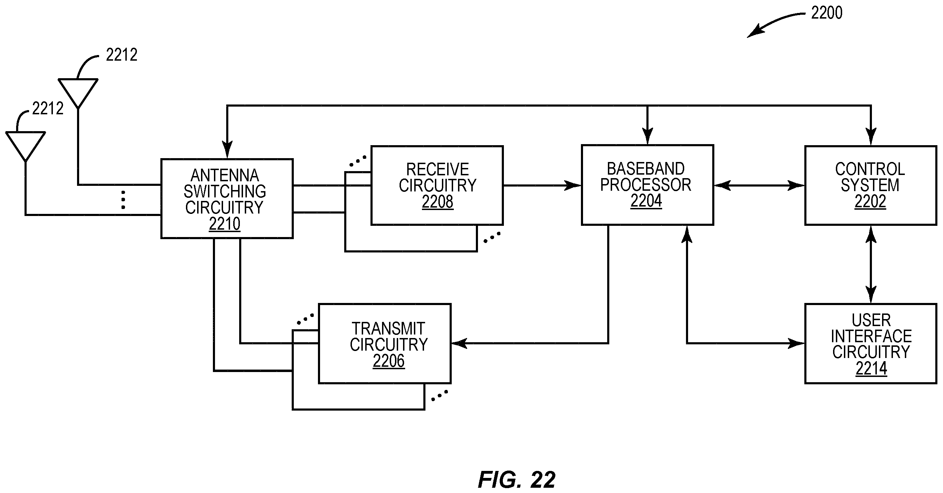

With reference to Figure 22, the concepts described above may be implemented in various types of user elements 2200, such as mobile terminals, smart watches, tablets, computers, navigation devices, access points, and like wireless communication devices that support wireless communications, such as cellular, wireless local area network (WLAN), Bluetooth, and near field communications. The user elements 2200 will generally include a control system 2202, a baseband processor 2204, transmit circuitry 2206, receive circuitry 2208, antenna switching circuitry 2210, multiple antennas 2212, and user interface circuitry 2214. In a non-limiting example, the control system 2202 can be a field-programmable gate array (FPGA) or an application-specific integrated circuit (ASIC), as an example. In this regard, the control system 2202 can include at least a microprocessor(s), an embedded memory circuit(s), and a communication bus interface(s). The receive circuitry 2208 receives radio frequency signals via the antennas 2212 and through the antenna switching circuitry 2210 from one or more base stations. A low noise amplifier and a filter of the receive circuitry 2208 cooperate to amplify and remove broadband interference from the received signal for processing. Downconversion and digitization circuitry (not shown) will then downconvert the filtered, received signal to an intermediate or baseband frequency signal, which is then digitized into one or more digital streams using an analog-to-digital converter(s) (ADC).

The baseband processor 2204 processes the digitized received signal to extract the information or data bits conveyed in the received signal. This processing typically comprises demodulation, decoding, and error correction operations. The baseband processor 2204 is generally implemented in one or more digital signal processors (DSPs) and ASICs.

For transmission, the baseband processor 2204 receives digitized data, which may represent voice, data, or control information, from the control system 2202, which it encodes for transmission. The encoded data is output to the transmit circuitry 2206, where a digital-to-analog converter(s) (DAC) converts the digitally encoded data into an analog signal, and a modulator modulates the analog signal onto a carrier signal that is at a desired transmit frequency or frequencies. A power amplifier will amplify the modulated carrier signal to a level appropriate for transmission and deliver the modulated carrier signal to the antennas 2212 through the antenna switching circuitry 2210 to the antennas 2212. The multiple antennas 2212 and the replicated transmit and receive circuitries 2206, 2208 may provide spatial diversity. Modulation and processing details will be understood by those skilled in the art.

Therefore, from one perspective, there have been described A multigenerational front-end module (FEM) is disclosed. In particular, a FEM having a single transmission path may include a single power amplifier with supporting elements such as for example, bias levels, load modulation, supply voltages, or the like, that may be reconfigured and tuned so as to allow the single power amplifier to adapt effectively and work with different generations of wireless protocols. The use of such an adaptive, reconfigurable, tunable transmission path allows smaller and more cost-effective FEMs to be provided. Settings for the various changes may be stored in a look-up table (LUT) or the like.

Further examples of feature combinations taught by the present disclosure are set out in the following numbered clauses.

Clause 1. A front-end module (FEM) comprising: a main power amplifier; a plurality of adjustable elements associated with the main power amplifier; a control circuit coupled to each of the plurality of adjustable elements and configured to: responsive to receiving a command to operate the main power amplifier in a second-generation cellular mode, command at least one of the plurality of adjustable elements to change operation based on information in a look-up table (LUT); and responsive to receiving a second command to operate the main power amplifier in a subsequent generation cellular mode, command the at least one of the plurality of adjustable elements to change operation.

Clause 2. The FEM of clause 1, wherein the plurality of adjustable elements comprises at least one adjustable bias circuit.

Clause 3. The FEM of clause 1 or 2, wherein the plurality of adjustable elements comprises at least one attenuator.

Clause 4. The FEM of clause 1, 2 or 3, further comprising a driver amplifier coupled to the main power amplifier.

Clause 5. The FEM of any of clauses 1 to 4, wherein the plurality of adjustable elements comprises at least one variable load coupled to an output of the main power amplifier.

Clause 6. The FEM of any of clauses 1 to 5, wherein the main power amplifier comprises a transistor configured to operate in a first class for the second-generation cellular mode and a second class for the subsequent generation cellular mode.

Clause 7. The FEM of any of clauses 1 to 6, further comprising a power management integrated circuit (PMIC) comprising a first direct current to direct current (DC-DC) buck-boost converter and a second DC-DC buck-boost converter, wherein the control circuit is configured to cause outputs of the first DC-DC buck-boost converter and the second DC-DC buck-boost converter to be combined in the when operating in the second-generation cellular mode.

Clause 8. The FEM of any of clauses 1 to 7, wherein the control circuit is configured to cause the at least one of the plurality of adjustable elements to adjust an operating bandwidth.

Clause 9. The FEM of any of clauses 1 to 8, further comprising a predriver amplifier wherein the control circuit is configured to cause a signal to bypass the predriver amplifier when operating in the subsequent generation cellular mode.

Clause 10. The FEM of clause 9, wherein the control circuit is configured to cause the signal to pass through the predriver amplifier when operating in the second-generation cellular mode.

Clause 11. A mobile communication device comprising : a baseband processor (BBP); a transceiver circuit coupled to the BBP; an antenna; and a front-end module (FEM) coupled to the antenna and the transceiver circuit, the FEM comprising: a main power amplifier; a plurality of adjustable elements associated with the main power amplifier; a control circuit coupled to each of the plurality of adjustable elements and configured to: responsive to receiving a command to operate the main power amplifier in a second-generation cellular mode, command at least one of the plurality of adjustable elements to change operation based on information in a look-up table; and responsive to receiving a second command to operate the main power amplifier in a subsequent generation cellular mode, command the at least one of the plurality of adjustable elements to change operation.

Clause 12. The mobile communication device of clause 11, further comprising a communication bus communicatively coupling the BBP to the FEM, the BBP configured to send information regarding at least a cellular generation mode to the FEM over the communication bus.

Clause 13. The mobile communication device of clause 11 or 12, further comprising a second main power amplifier, and wherein the FEM is configured to use the main power amplifier and the second main power amplifier to provide carrier aggregation for a signal to be transmitted.

Clause 14. A method of changing operation of a front-end module (FEM), comprising: receiving an indication at the FEM for operation in a second-generation cellular mode; responsive to receiving the indication causing at least one adjustable element in the FEM to change operation; receiving a second indication at the FEM for operation in a subsequent generation cellular mode; and responsive to receiving the second indication, causing the at least one adjustable element in the FEM to further change operation.

Clause 15. The method of clause 14, wherein causing the at least one adjustable element to change operation comprises changing operation of an adjustable bias associated with a power amplifier.

Clause 16. The method of clause 14 or 15, further comprising changing a class of operation for a transistor in a power amplifier responsive to receiving the indication.

Clause 17. The method of clause 14, 15 or 16, further comprising combining signals from a first power amplifier whose operation is changed by the at least one adjustable element and a second power amplifier to provide carrier aggregation.

Clause 18. The method of any of clauses 14 to 17, further comprising combining outputs from two direct current to direct current (DC-DC) buck-boost converters when operating the second-generation cellular mode.

Clause 19. A front-end module (FEM) comprising: a primary power amplifier stage; a silicon prestage structure positioned in front of the primary power amplifier stage, the silicon prestage structure comprising a plurality of adjustable elements associated with the primary power amplifier stage; a control circuit coupled to each of the plurality of adjustable elements and configured to: responsive to receiving a command to operate the primary power amplifier stage in a first mode, command at least one of the plurality of adjustable elements to change operation based on information in a look-up table (LUT); and responsive to receiving a second command to operate the primary power amplifier stage in a different mode, command the at least one of the plurality of adjustable elements to change operation.

Clause 20. The FEM of clause 19, further comprising a poststage structure positioned after the primary power amplifier stage, the poststage structure comprising a second plurality of adjustable elements.

Clause 21. The FEM of clause 20, wherein the poststage structure is formed in silicon.

Clause 22. The FEM of clause 20 or 21, further comprising a second power detector positioned in the poststage structure.

Clause 23. The FEM of clause 22, further comprising an overcurrent protection circuit positioned in the silicon prestage structure.

Clause 24. The FEM of clause 22 or 23, further comprising a first predistortion circuit responsive to correct distortions introduced by the primary power amplifier stage.

Clause 25. The FEM of any of clauses 19 to 24, wherein the control circuit is at least partially formed in silicon.

Clause 26. The FEM of any of clauses 19 to 25, further comprising a power detector positioned in the silicon prestage structure.

It is also noted that the operational steps described in any of the example aspects herein are described to provide examples and discussion. The operations described may be performed in numerous different sequences other than the illustrated sequences. Furthermore, operations described in a single operational step may actually be performed in a number of different steps. Additionally, one or more operational steps discussed in the example aspects may be combined. It is to be understood that the operational steps illustrated in the flowchart diagrams may be subject to numerous different modifications, as will be readily apparent to one of skill in the art. Those of skill in the art will also understand that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

The previous description of the disclosure is provided to enable any person skilled in the art to make or use the disclosure. Various modifications to the disclosure will be readily apparent to those skilled in the art, and the generic principles defined herein may be applied to other variations. Thus, the disclosure is not intended to be limited to the examples and designs described herein but is to be accorded the widest scope consistent with the principles and novel features disclosed herein.

## Claims

1. A front-end module, FEM, comprising:
a power amplifier;
a plurality of adjustable elements associated with the power amplifier;
a control circuit coupled to each of the plurality of adjustable elements and configured to:
responsive to receiving a command to operate the power amplifier in a first mode, command at least one of the plurality of adjustable elements to change operation based on information in a look-up table; and
responsive to receiving a second command to operate the power amplifier in a different mode, command the at least one of the plurality of adjustable elements to change operation.

2. The FEM of claim 1, wherein:
the power amplifier is a main power amplifier;
the first mode is a second-generation cellular mode; and
the different mode is a subsequent generation cellular mode.

3. The FEM of claim 2, wherein the plurality of adjustable elements comprises one or more selected from the group comprising: at least one adjustable bias circuit; at least one attenuator; and at least one variable load coupled to an output of the main power amplifier.

4. The FEM of claim 2 or 3, further comprising a driver amplifier coupled to the main power amplifier.

5. The FEM of any of claims 2 to 4, wherein the main power amplifier comprises a transistor configured to operate in a first class for the second-generation cellular mode and a second class for the subsequent generation cellular mode.

6. The FEM of any of claims 2 to 5, further comprising a power management integrated circuit, PMIC, comprising a first direct current to direct current, DC-DC, buck-boost converter and a second DC-DC buck-boost converter, wherein the control circuit is configured to cause outputs of the first DC-DC buck-boost converter and the second DC-DC buck-boost converter to be combined in the when operating in the second-generation cellular mode.

7. The FEM of any of claims 2 to 6, wherein the control circuit is configured to cause the at least one of the plurality of adjustable elements to adjust an operating bandwidth.

8. The FEM of any of claims 2 to 7, further comprising a predriver amplifier wherein the control circuit is configured to cause a signal to bypass the predriver amplifier when operating in the subsequent generation cellular mode, and for example wherein the control circuit is configured to cause the signal to pass through the predriver amplifier when operating in the second-generation cellular mode.

9. The FEM of claim 1 wherein:
the power amplifier is a primary power amplifier stage;
the FEM further comprising a silicon prestage structure positioned in front of the primary power amplifier stage, the silicon prestage structure comprising the plurality of adjustable elements, and for example further comprising an overcurrent protection circuit and/or a power detector positioned therein.

10. The FEM of claim 9, further comprising a poststage structure, optionally formed in silicon, positioned after the primary power amplifier stage, the poststage structure comprising a second plurality of adjustable elements, and for example further comprising a second power detector positioned in the poststage structure.

11. The FEM of claim 9 or 10, further comprising a first predistortion circuit responsive to correct distortions introduced by the primary power amplifier stage.

12. The FEM of any of claims 9 to 11, wherein the control circuit is at least partially formed in silicon.

13. A mobile communication device comprising:
a baseband processor, BBP;
a transceiver circuit coupled to the BBP;
an antenna; and
the front-end module, FEM, or any of claims 1 to 12, coupled to the antenna and the transceiver circuit.

14. The mobile communication device of claim 13, further comprising a communication bus communicatively coupling the BBP to the FEM, the BBP configured to send information regarding at least a cellular generation mode to the FEM over the communication bus.

15. The mobile communication device of claim 13 or 14, further comprising a second main power amplifier, and wherein the FEM is configured to use the main power amplifier and the second main power amplifier to provide carrier aggregation for a signal to be transmitted.

16. A method of changing operation of a front-end module, FEM, comprising:
receiving an indication at the FEM for operation in a second-generation cellular mode;
responsive to receiving the indication causing at least one adjustable element in the FEM to change operation;
receiving a second indication at the FEM for operation in a subsequent generation cellular mode; and
responsive to receiving the second indication, causing the at least one adjustable element in the FEM to further change operation.

17. The method of claim 16, wherein causing the at least one adjustable element to change operation comprises changing operation of an adjustable bias associated with a power amplifier.

18. The method of claim 16 or 17, further comprising changing a class of operation for a transistor in a power amplifier responsive to receiving the indication.

19. The method of claim 16, 17 or 18, further comprising combining one or more selected from the group comprising: signals from a first power amplifier whose operation is changed by the at least one adjustable element and a second power amplifier to provide carrier aggregation; and outputs from two direct current to direct current, DC-DC, buck-boost converters when operating the second-generation cellular mode.
